# EUROPÄISCHE PATENTSCHRIFT

(11) **EP 0 954 875 B1**
(45) Veröffentlichungstag und Bekanntmachung des Hinweises auf die Patenterteilung: **02.01.2003**
(21) Anmeldenummer: 98905260.0
(22) Anmeldetag: 17.01.1998
(51) Int. Cl.: H01J 37/32

(54) **MODULATOR FÜR DIE PLASMAIMMERSIONS-IONENIMPLANTATION**
MODULATOR FOR PLASMA-IMMERSION ION IMPLANTATION
MODULATEUR POUR L'IMPLANTATION D'IONS PAR IMMERSION DANS UN PLASMA

(30) Priorität: 23.01.1997 DE 19702294
(43) Veröffentlichungstag der Anmeldung: 10.11.1999
(73) Patentinhaber: Forschungszentrum Rossendorf e.V., 01328 Dresden (DE)
(72) Erfinder: GÜNZEL, Reinhard, D-01277 Dresden (DE)
(86) Internationale Anmeldenummer: DE9800144
(87) Internationale Veröffentlichungsnummer: WO98033200

(56) Entgegenhaltungen:
- EP-A- 0 596 496
- DEB D ET AL: "Beam switch tube modulator technology for plasma ion implantation broad industrial applications" DIGEST OF TECHNICAL PAPERS. NINTH IEEE INTERNATIONAL PULSED POWER CONFERENCE (CAT. NO.93CH3350-6), PROCEEDINGS OF 9TH INTERNATIONAL PULSED POWER CONFERENCE, ALBUQUERQUE, NM, USA, 21-23 JUNE 1993, ISBN 0-7803-1416-6, 1993, NEW YORK, NY, USA, IEEE, USA, Seiten 333-336 vol.1, XP000531115
- ADLER R J ET AL: "Thyratron modulators in plasma source ion implantation" DIGEST OF TECHNICAL PAPERS. TENTH IEEE INTERNATIONAL PULSED POWER CONFERENCE (CAT. NO.95CH35833), DIGEST OF TECHNICAL PAPERS. TENTH IEEE INTERNATIONAL PULSED POWER CONFERENCE, ALBUQUERQUE, NM, USA, 3-6 JULY 1995, ISBN 0-7803-2791-8, 1995, NEW YORK, NY, USA, IEEE, USA, Seiten 1243-1248 vol.2, XP002064943
- GOEBEL D M: "HIGH POWER MODULATOR FOR PLASMA ION IMPLANTATION" JOURNAL OF VACUUM SCIENCE AND TECHNOLOGY: PART B, Bd. 12, Nr. 2, 1.März 1994, Seiten 838-842, XP000442757 in der Anmeldung erwähnt
- CONRAD J R ET AL: "PLASMA SOURCE ION-IMPLANTATION TECHNIQUE FOR SURFACE MODIFICATION OF MATERIALS" JOURNAL OF APPLIED PHYSICS, Bd. 62, Nr. 11, 1.Dezember 1987, Seiten 4591-4596, XP000049098 in der Anmeldung erwähnt

## Beschreibung

Die Erfindung betrifft mit dem Modulator für die Plasmaimmersions-Ionenimplantation (PIII) ein wesentliches Bauteil einer PIII-Anlage.
Bei der PIII wird ein zu implantierendes Werkstück innerhalb einer Implantationskammer in ein Plasma eingetaucht. Durch das Anlegen einer negativen Hochspannung an das Werkstück werden positive Ionen aus dem Plasma allseitig auf das Werkstück beschleunigt und in dieses implantiert. [J. R. Conrad, J. L. Radtke, R. A. Dodd, F. J. Worzala und Ngoc C. Tran, Plasma source ionimplantation technique for surface modification of materials, Journal of Applied Physics, 62, 1987, 4591-4596]. Die Stromdichte der implantierten Ionen ist abhängig von den Plasmaparametern und der gewählten Implantationsspannung und liegt während der Implantation in der Größenordnung von 1-10 mA/cm². Bei einer Beschleunigungsspannung von 50 kV beträgt der Energieeintrag daher bis zu 500 W/cm². Da dieser Energieeintrag nach wenigen Sekunden zu einer starken Aufheizung des Werkstücks führen würde, wird die negative Hochspannung nicht kontinuierlich, sondern nur gepulst an das Werkstück angelegt.
Ein weiterer Grund für die Pulsung der Hochspannung ist dadurch gegeben, daß bei größeren Werkstücken der erforderliche Strom nur mit beträchtlichem technischen Aufwand über längere Zeit aufrecht erhalten werden kann. Die Pulsdauer liegt zwischen 2 und 100 µs, bei einer Wiederholfrequenz von wenigen Hz bis kHz.
Ein wichtiges Bauteil einer PIII-Anlage ist demnach der sogenannte Modulator, der die Aufgabe hat, von einer gleichgerichteten Hochspannungsquelle die entsprechenden Hochspannungspulse an das zu implantierende Werkstück heranzuführen.
Aufbau und Funktionsweise der für die PIII bisher eingesetzten Modulatoren sind stets ähnlich: Die positive Elektrode eines Hochspannungserzeugers wird über einen Widerstand mit einem Kondensator verbunden, dessen zweiter Anschluß über eine Hochspannungsdurchführung mit dem, das zu implantierende Werkstück tragenden Bearbeitungstisch innerhalb der Implantationskammer verbunden ist. Die andere Elektrode des Hochspannungserzeugers wird als Massepotential 0 mit der Implantationskammer verbunden. Außerdem ist an einem zwischen dem Widerstand und dem Kondensator befindlichen Verknüpfungspunkt ein Schalter angeordnet, der das Zuschalten von Massepotential an diesen Pol des Kondensators, und damit über dessen Lade/Entladesteuerung die Hochspannungspulsung am Werkstück ermöglicht. Da dieser Schalter Hochspannungen von mehreren 10 keV bei teilweise erheblich hohen Strömen schalten muß, stellen derzeit für die Belange der PIII kommerziell verfügbare Schalter auch einen beträchtlichen Kostenfaktor dar. Bei kleineren, insbesondere für Forschungszwecke ausgelegten Anlagen können noch verhältnismäßig preiswerte Schalter auf Halbleiter-Basis verwendet werden. Mit diesen Schaltern können Implantationsspannungen von bis zu 40 kV bei Strömen bis zum A-Bereich geschalten werden. Sollen größere Ströme geschalten werden, so müssen teure Senderöhren, die beispielsweise bei Spannungen bis zu 40 kV für Ströme bis zu 200 A erhältlich sind, verwendet werden. Noch höhere Ströme bis zu 1 kA können bisher mit den sog. "Crossatrons" geschalten werden [D. M. Goebel, High power modulator for PII, J. Vac. Sci. Technol. B, Vol. 12, 2, 1994, 838-842 ].
Eine weitere Steigerung der zu schaltenden Ströme ist nur mit extrem aufwendigen Spezialanfertigungen, wie sie aus der Fusionsforschung her bekannt sind, möglich [B. J. Wood, J. T. Scheuer, M. A. Nastasi, R. H. Olsher, W. A. Reass, I. Henins und D. J. Rej, Design of a large-scale plasma source ion implantation experiment, Materials Research Society Symposium Procedings, V 279, 1993, Materials Research Society, Pittsburgh, PA, USA, 345-350].
Aufgabe der Erfindung ist es, mit geringerem technischen und finanziellen Aufwand, die bei der PIII während der Wirkung des Hochspannungspulses fließenden großen Ströme unter Hochspannung ein- und auszuschalten.

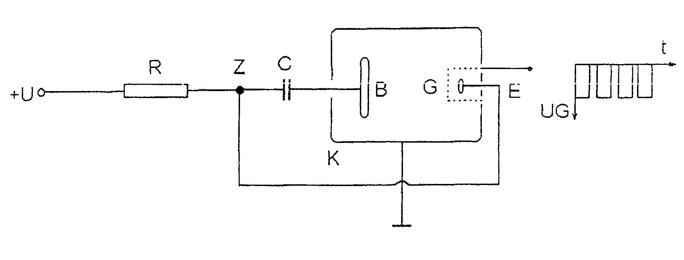

Erfindungsgemäß wird diese Aufgabe durch den im Patentanspruch beschriebenen Modulator gelöst, indem der aus dem Stand der Technik bekannte Schalter nicht als technisch eigenständige Einheit beigestellt, sondern in Form einer über ein Abschirmgitter steuerbaren Zusatzelektrode in die Implantationskammer integriert wird.
Das Abschirmgitter, das die in den Plasmaraum eintauchende Elektrode umgibt, gewährleistet durch das Anlegen steuerbarer Gitterspannungen, daß die zusätzliche Elektrode vom Plasma entweder isoliert ist, oder aber im elektrischen Kontakt mit diesem steht. In letzterem Fall wird, analog geschlossenem Schalter im oben beschriebenen Modulator, der Entladestromkreis des Kondensators geschlossen.
Die Erfindung soll nachfolgend unter Bezugnahme auf die Zeichnung näher erläutert werden.

In der Zeichnung ist mit +U der positive Pol des Hochspannungserzeugers über einen Widerstand R mit dem Kondensator C verbunden, dessen zweiter Pol über eine Hochspannungsdurchführung mit dem Bearbeitungstisch B innerhalb der Implantationskammer K verbunden ist.
Die Implantationskammer selbst liegt wie auch der zweite Pol des Hochspannungserzeugers auf Massepotential. Zwischen R und C liegt der Verknüpfungspunkt Z, der seinerseits über eine Hochspannungsdurchführung mit der zusätzlichen Elektrode E innerhalb der Implantationskammer K verbunden ist. Diese Elektrode ist gegenüber dem Plasma P durch ein mit negativer Steuerspannung UG beaufschlagbares Gitter G abgeschirmt. Um die Ausbreitung der Plasmarandschicht nicht zu stören, werden die Elektrode E und das sie umgebende Gitter G in genügender Entfernung vom Behandlungsgut in der Implantationskammer K angeordnet und gegen diese isoliert.

Die Funktion dieses erfindungsgemäßen Modulators ist folgendermaßen:

Befindet sich in der Implantationskammer K ein elektrisch leitfähiges Plasma, so wird durch das Plasma der mit dem Bearbeitungstisch verbundene zweite Anschluß des Kondensators ebenfalls auf dem Potential der Implantationskammer K (Massepotential) gehalten, d. h. der Kondensator wird von der Hochspannungsquelle aufgeladen, solange die Elektrode E mittels negativer Gitterspannung UG vom Plasma isoliert ist.
Die elektrische Isolation der Elektrode E zum Plasma wird dabei auf folgende Weise erzielt: In Abhängigkeit von der Elektronentemperatur und der Maschenweite des Abschirmgitters wird die negative Gitterspannung des Abschirmgitters so festgelegt, daß die thermischen Elektronen des Plasmas das Abschirmgitter nicht passieren können, wozu etwa der zehn- bis hundertfache Wert der Elektronentemperatur erforderlich ist. Die positiven Ionen des Plasmas, die das negativ geladene Gitter passieren können, können wiederum das positive Potential (+U) der Elektrode E nicht überwinden, so daß bei negativer Gitterspannung UG die Elektrode E elektrisch vom Plasma isoliert ist.
Wird an das Gitter G die Gitterspannung UG = 0 gelegt, so können Elektronen aus dem Plasma das Gitter passieren und werden durch das positive Potential der Elekrode E auf diese hin beschleunigt. Diese Beschleunigung wird solange erfolgen, wie die Elektrode E positiv gegenüber dem Plasma potential (einige Volt) geladen ist. Da hierdurch die Elektrode E und damit auch der Anschluß Z des Kondensators C praktisch auf Massepotential gesetzt wird, wechselt jetzt die mit dem Bearbeitungstisch B verbundene Elektrode des Kondensators C und damit auch des Bearbeitungstisches B das Potential nach -U (Hochspannungspuls).
Der Hochspannungserzeuger ist jetzt über den ausreichend bemessenen Widerstand R mit Masse verbunden.

Da sich nun der Bearbeitungstisch B und auch darauf befindliches Behandlungsgut bezüglich des umgebenden Plasmas auf negativem Potential befinden, werden aus dem Plasma positiv geladene Ionen in Richtung Bearbeitungstisch B beschleunigt und infolge der durch die Potentialdifferenz zwischen Plasma und Bearbeitungstisch B erhaltenen Geschwindigkeit in das Behandlungsgut implantiert.
Hiermit ist auch der Entladestromkreis des Kondensators C geschlossen, da die positiv geladenen Ionen den Bearbeitungstisch und das Behandlungsgut erreichen und die Elektronen zur Elektrode E beschleunigt werden.
Durch Anlegen der negativen Gitterspannung UG an das Abschirmgitter der Elektrode E wird die Elektrode E in der oben beschriebenen Weise wieder vom Plasma elektrisch isoliert, wodurch der Entladevorgang des Kondensators unterbrochen wird. Der Bearbeitungstisch wird durch das Plasma wieder auf Plasmapotential gehalten. Der Implantationsvorgang ist beendet, der Kondensator wird wieder nachgeladen.
Die Dauer und die Wiederholrate eines solchen Implantationszyklus sind variabel. Die Entladezeiten des Kondensators C und damit die Implantationszeiten betragen gewöhnlich einige µs bis zu 100µs, während die Wiederholraten bis zu mehreren kHz betragen. Die Kapazität des Kondensators C ist dabei so bemessen, daß während des Entladevorgangs nur eine teilweise Entladung des Kondensators erfolgt.
Werden während der Entladephase des Kondensators C nur soviele Elektronen aus dem Plasma extrahiert, wie Ionen implantiert werden, erfolgt keine Störung der Ladungsträgerbilanz des Plasmas. Es werden beim Auftreffen der Ionen auf das Behandlungsgut jedoch auch Sekundärelektronen ausgelöst, die, falls keine Sekundärelektronenunterdrückung vorgesehen ist, auf Grund der gegebenen Potentialdifferenz vom Behandlungsgut weg zur Kammerwand hin beschleunigt werden. Dadurch muß durch die Elektrode E ein zusätzlicher Elektronenstrom vom gleichen Betrage, wie der Sekundärelektronenstrom, dem Plasma entzogen werden. Die Ladungsträgerbilanz des Plasmas gleicht sich jedoch auch hier aus, da eine Verschiebung des Plasmapotentials zu positiven Werten hin erfolgt, wodurch der Strom der thermischen Elektronen des Plasmas zur Kammerwand hin entsprechend verringert wird. Dieser Ausgleich wird auch durch die beim Auftreffen der Sekundärelektronen auf die Kammerwand dort ausgelösten Elektronen unterstützt. Die Größe des durch die beschleunigten Ionen und Elektronen gebildeten Stromes ist abhängig von den Plasmaparametern und der Potentialdifferenz zwischen Bearbeitungstisch und Plasma. Die üblicherweise auftretenden Stromdichten liegen bei ca 0,1 bis 1 A/cm² und sind zu Beginn des Pulses am höchsten. Nach mehreren µs fällt die Stromdichte auf einen stationären Wert ab.
Bei größeren, praxisrelevanten Bearbeitungsgütern mit einer Oberfläche von ca 1m² ergibt sich damit ein Strom im Puls von bis zu 10 kA. Die oben beschriebene Funktion des Modulators ist solange gewährleistet, wie der während der Implantationsphase im Puls von der Elektrode E zu extrahierende Elektronenstrom kleiner ist, als der auf die Kammerwand auftreffende Strom thermischer Elektronen des Plasmas.
Das ist bei der PIII stets gegeben.

Die Vorteile der Erfindung bestehen in der erheblichen Kostenersparnis insbesondere, wenn größere Werkstückoberflächen durch PIII behandelt werden sollen. Beispielsweise sind bei der Verwendung von Elektronenröhren aufwendige und teure Katodenheizungen notwendig. Auch ist bei der dargelegten Erfindung ein einfacher Ersatz verschlissener Bauteile (Gitter ) möglich.

## Patentansprüche

1. Modulator für die Steuerung der hochspannungsgepulsten Plasmaimmersions-Ionenimplantation, bei dem ein innerhalb einer Implantationskammer angeordneter Bearbeitungstisch über einen Kondensator und einen Widerstand mit einer Hochspannungsquelle verbunden ist, **dadurch gekennzeichnet, daß** der dem Bearbeitungstisch abgewandte Pol des Kondensators mit einer in der Implantationskammer angeordneten, über ein Gitter gegenüber dem Plasma abgeschirmten zusätzlichen Elektrode verbunden ist, und daß das Gitter wiederum mit einem Pulserzeuger zur Erzeugung negativer Spannungspulse im Bereich von 1 - 2000V verbunden ist.

## Claims

1. Modulator for the control of high-voltage pulsed plasma-immersion ion implantation, in which a processing table located within an implantation chamber is connected to a high-voltage supply source by means of a capacitor and a resistor, **characterized in that** the pole of the capacitor facing away from the processing table is connected with an additional electrode located in the implantation chamber and shielded from the plasma by means of a screen, and that the screen is connected with a pulse generator for producing reverse voltage pulses of 1 - 2000V.

## Revendications

1. Modulateur pour la commande de l'implantation d'ions par immersion dans un plasma et pulsée à haute tension, dans lequel un plateau de traitement disposé à l'intérieur d'une chambre d'implantation est relié à une source de haute tension par un condensateur et par une résistance, **caractérisé par le fait que** le pôle du condensateur qui n'est pas dirigé vers le plateau de traitement est relié à une électrode supplémentaire disposée dans la chambre d'implantation et protégée contre le plasma par une grille, et que la grille pour sa part est reliée à un générateur de pulsations servant à la génération de pulsations de tension négative dans la plage de 1 à 2000 V.
